# EUROPEAN PATENT APPLICATION

(11) **EP 4 098 776 A1**
(43) Date of publication of application: **07.12.2022**
(21) Application number: 21748376.7
(22) Date of filing: 28.01.2021
(51) Int. Cl.: C25D 1/08, C25D 1/00, C25D 1/04, H05K 1/09

(54) **METAL FOIL AND PRODUCTION METHOD THEREFOR, AND METHOD FOR PROCESSING ELECTRODEPOSITION DRUM TO BE USED FOR SAID PRODUCTION METHOD**

(30) Priority: 31.01.2020 JP 2020015131
(71) Applicant: Nippon Denkai, Ltd., Chikusei-shi Ibaraki 308-0851 (JP)
(72) Inventor: KOGUCHI, Hiroshi, Chikusei-shi, Ibaraki 308-0851 (JP); SAGIYA, Yuya, Chikusei-shi, Ibaraki 308-0851 (JP); YAGIHASHI, Nobuchika, Chikusei-shi, Ibaraki 308-0851 (JP)
(74) Representative: HGF
(86) International application number: PCT/JP2021/002957
(87) International publication number: WO 2021/153647

(57) **Abstract**

A metal foil has a cathode surface on which no linear indentations exist when viewed microscopically, a production method for the same, and a processing method for an electrodeposition drum used for the same. A surface of the electrodeposition drum for producing the metal foil is irradiated with a laser to process this surface into a pattern of repeated curved shapes including a plurality of dot-shaped dents or the like. With this, the pattern of repeated curved shapes is formed on the surface of the electrodeposition drum. The electrodeposition drum thus processed is used as a cathode, supply of electricity is provided between the electrodeposition drum and an anode plate that are soaked in an electrolytic solution to electrodeposit metal on the surface of the drum with an electrolytic reaction, and thereafter, the metal is peeled off from the electrodeposition drum, thereby yielding the metal foil. The metal foil thus obtained has a pattern corresponding to the pattern of repeated curved shapes including a plurality of dot-shaped bumps or the like on the cathode surface thereof.

## Description

### TECHNICAL FIELD

The present invention relates to a metal foil, to a method for producing the same, and to a method for processing an electrodeposition drum to be used for the same.

### BACKGROUND ART

A metal foil of copper, chrome, nickel, tin, zinc, or an alloy foil of these metals (hereinafter, also simply referred to as a "metal foil") is generally produced, as described in Patent Document 1, by causing an electrolytic reaction between an electrodeposition drum as a cathode disposed in an electrolytic cell containing an electrolytic solution, and an electrode plate as an anode disposed opposite to the electrodeposition drum via a gap therebetween to electrodeposit the metal on the surface of the electrodeposition drum, and thereafter peeling off this metal.

### REFERENCE DOCUMENT LIST

### PATENT DOCUMENT

Patent Document 1: JP 2001-342590 A

### SUMMARY OF THE INVENTION

### PROBLEM TO BE SOLVED BY THE INVENTION

The metal foil thus peeled off from the electrodeposition drum has: a cathode surface that has luster and located on the contact side of the electrodeposition drum; and a deposition surface that is plated and located on the opposite side thereof. The cathode surface of the metal foil has luster because the surface of the electrodeposition drum is smoothly polished, and the condition of this smooth-polished surface is exactly reflected on the cathode surface of the metal foil. Conventionally, a grindstone has been used for polishing a surface of an electrodeposition drum, and smooth polishing is performed on the surface. However, due to polishing with a grindstone, there exist linear indentations in a certain direction when viewed under a microscope. Although the cathode surface of the metal foil, produced by the electrodeposition drum having a surface on which such linear indentations exist in a certain direction, has luster, the cathode surface reflects the profile of the drum surface, so that there exist microscopic linear indentations thereon. In general, even if such linear indentations exist on the surface of the metal foil, there is no particular problem as long as the height or the depth of the indentations is within several µm; however, depending on the application of the metal foil, such linear indentations may cause a problem.

In light of the above problem, an object of the present invention is to provide a metal foil with a cathode surface having no linear indentations thereon when viewed microscopically, a method for producing of the same, and a method for processing an electrodeposition drum to be used for the same.

### MEANS FOR SOLVING THE PROBLEM

To achieve the above object, the present invention is, as one aspect thereof, a method for processing a surface of an electrodeposition drum for producing a metal foil, and the method includes a step of irradiating a surface of the electrodeposition drum with a laser to process the surface of the electrodeposition drum into a pattern of repeated curved shapes.

In the surface processing method of the electrodeposition drum, it is preferable that a plurality of dot-shaped dents be formed on the surface of the electrodeposition drum by the laser irradiation.

The present invention is, in another aspect thereof, a method of producing a metal foil, the method including a step of providing a supply of electricity between an electrodeposition drum as a cathode and an anode that are soaked in an electrolytic solution to electrodeposit metal on a surface of the electrodeposition drum with an electrolytic reaction, and thereafter peeling off the metal from the electrodeposition drum to obtain the metal foil, and the electrodeposition drum has a processed surface having a pattern of repeated curved shapes by laser irradiation.

In the metal foil producing method, it is preferable that the curved shapes be dot-shaped dents.

It is preferable that, by the processed surface of the electrodeposition drum having the pattern of repeated curved shapes, a cathode surface of the metal foil, which is in contact with the electrodeposition drum, be formed with a pattern corresponding to the pattern of repeated curved shapes.

It is preferable that a surface profile formed on a deposition surface of the metal foil, which is opposite to the cathode surface, be controlled by the processed surface of the electrodeposition drum having the pattern of repeated curved shapes.

The present invention is, in yet another aspect thereof, an electrolytic metal foil having a pattern of repeated curved shapes on a cathode surface of the electrolytic metal foil.

In this electrolytic metal foil, it is preferable that the curved shapes be dot-shaped bumps. It is preferable that the dot-shaped bumps have an average diameter of up to 100 µm. In addition, it is preferable that a surface roughness Rz of the cathode surface of the electrolytic metal foil be up to 10 µm.

It is preferable that an aspect ratio Str of a surface texture of the cathode surface of the electrolytic metal foil be 0.6 to 1.0. In addition, it is preferable that a surface roughness Rz of the cathode surface of the electrolytic metal foil be 1/100 to 1/10 of an average diameter of the dot-shaped bumps of the cathode surface of the electrolytic metal foil.

The present invention is, in yet another aspect thereof, a lithium-ion battery or a printed circuit board including the above-described electrolytic metal foil.

### EFFECTS OF THE INVENTION

According to the present invention, since the surface of the electrodeposition drum for producing the metal foil is irradiated with a laser to process the surface of the electrodeposition drum into a pattern of repeated curved shapes, it is possible to prevent linear indentations caused by conventional polishing with a grindstone from being formed on the drum surface. Conventionally, laser processing has been used for forming fine shapes in a certain narrow area, and an electrodeposition drum for producing a metal foil generally has a diameter of several meters and a length of several meters; however, the inventors of the present application have accomplished, for the first time, laser processing used for processing a surface having such a large area into a pattern of repeated curved shapes including a plurality of dot-shaped dents and bumps or the like. The cathode surface of the metal foil, thus produced by the electrodeposition drum processed by a laser into the pattern of repeated curved shapes, can be formed into a superior surface having luster and no linear indentations when viewed microscopically. In particular, in the conventional polishing with a grindstone, burrs and protrusions derived from the polishing are generated on the cathode surface of the metal foil obtained; however, the processing with the laser irradiation of the present invention can prevent such burrs and protrusions.

### BRIEF DESCRIPTION OF THE DRAWINGS

FIG. 1 is a schematic diagram for explaining an embodiment of a metal foil producing method according to the present invention.
FIG. 2 is a schematic diagram for explaining an embodiment of a processing method of an electrodeposition drum for the metal foil producing method according to the present invention.
FIG. 3 is a laser microscope image showing an example of a surface of the electrodeposition drum obtained by a surface processing method of the electrodeposition drum according to the present invention.
FIG. 4 is a laser microscope image showing an example of a surface of an electrodeposition drum obtained by a conventional surface processing method of an electrodeposition drum.
FIG. 5 is a scanning electron microscope image showing an example of a surface of a cathode surface of a metal foil obtained by the metal foil producing method according to the present invention.
FIG. 6 is a scanning electron microscope image showing an example of a surface of a deposition surface of the metal foil obtained by the metal foil producing method according to the present invention.
FIG. 7 is a scanning electron microscope image showing an example of a surface of a cathode surface of a metal foil obtained by a conventional metal foil producing method.
FIG. 8 is a scanning electron microscope image showing an example of a surface of a deposition surface of the metal foil obtained by the conventional metal foil producing method.

### MODE FOR CARRYING OUT THE INVENTION

Hereinafter, embodiments of a metal foil producing method according to the present invention will be described with reference to the accompanying drawings.

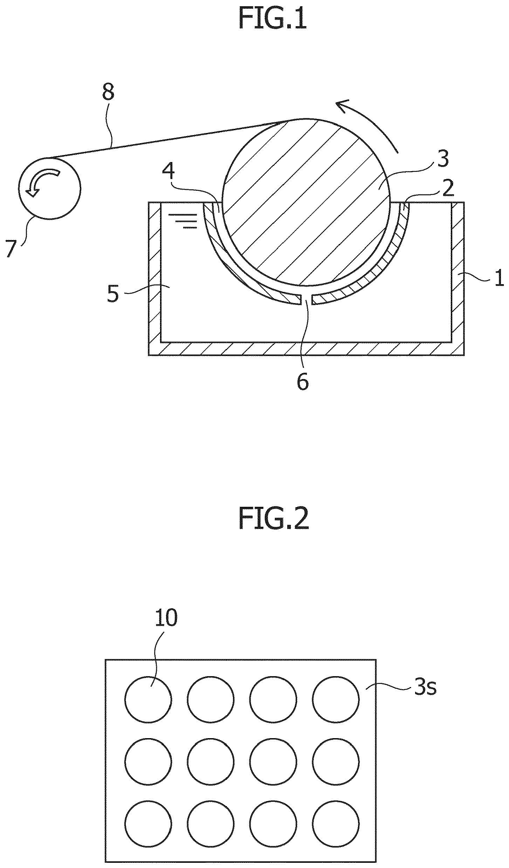

As shown in FIG. 1, a device for producing a metal foil includes: an electrodeposition drum 3 serving as a cathode and rotating while being housed by half in an electrolytic cell 1; and an anode plate 2 having a curved shape surrounding substantially the half of the electrodeposition drum 3 on the electrolytic cell 1 side. A surface of the electrodeposition drum 3 is formed of, for example, an alloy of titanium, nickel, chromium, stainless steel, or the like. The electrodeposition drum 3 generally has a diameter of 1 to 3 m and a length of 1 to 3 m, for example, a diameter of 2 m and a length of 2 m. The anode plate 2 is made of, for example, lead, platinum-coated titanium, iridium-coated titanium, or the like. The anode plate 2 and the electrodeposition drum 3 are arranged to face each other with a gap 4 at a predetermined distance therebetween.

Depending on the metal foil to be produced, an electrolytic solution 5 containing said metal as a main component is housed in the electrolytic cell 1. For example, when a copper foil is produced as the metal foil, as the electrolytic solution 5, for example, a sulfuric acid-based copper electrolytic solution containing copper sulfate as a main component is preferably used. The sulfuric acid-based copper electrolytic solution preferably has a copper concentration of 60 to 90 g/L and a sulfuric acid concentration of 50 to 200 g/L. Furthermore, the anode plate 2 is provided with an opening 6 through which the electrolytic solution 5 can be distributed.

According to said device, an electrolytic reaction of the electrolytic solution 5 is caused by rotating the electrodeposition drum 3 in a direction indicated by an arrow in FIG. 1, while supplying the electrolytic solution 5 from the opening 6 of the anode plate 2 into the gap 4 between the anode plate 2 and the electrodeposition drum 3, and providing a supply of electricity between the anode plate 2 and the electrodeposition drum 3 with a predetermined current density. With this configuration, metal is electrodeposited on the surface of the electrodeposition drum 3; and as the electrodeposition drum 3 is rotated, the thickness of the metal deposited from the electrolytic solution gradually increases. When the metal has a predetermined thickness, the metal is peeled off from the electrodeposition drum 3 by a guide roller (not shown) to obtain the metal foil 8. The metal foil 8 thus peeled off is continuously wound up by a wind-up roll 7, and thereby continuously producing the metal foil 8 in a long shape. The metal foil 8 thus produced has: a cathode surface having luster and located on the electrodeposition drum 3 side; and a deposition surface on the opposite side thereof, that is, on the electrolytic solution 5 side, the deposition surface is so called because of being located in a growth direction of crystals of the metal foil 8.

The cathode surface of the metal foil 8 has luster because the drum surface of the electrodeposition drum 3 is smoothly polished, and the condition of this smoothly polished surface is exactly reflected on the surface of the metal foil 8. Conventionally, a grindstone is used for polishing the surface of the electrodeposition drum 3, and mirror polishing or smooth polishing close to a mirror surface is performed. However, because of the polishing with a grindstone, linear indentations exist in a certain direction when viewed microscopically. Hence, even though the cathode surface of the metal foil, produced by using the electrodeposition drum having the surface on which linear indentations are present in a certain direction, has luster, linear indentations are microscopically generated. Generally, even if such linear indentations exist in the metal foil, the height or depth of the indentations is within several µm, and there is no particular problem; however, depending on the application of the metal foil, such linear indentations may cause a problem.

In the metal foil producing method of the present embodiment, a drum surface 3 s of the electrodeposition drum 3, which is processed into a mirror surface or a smooth surface close to a mirror surface, is used; and as shown in FIG. 2, when viewed microscopically, there are a plurality of dot-shaped dents 10s, such as circles, in the axial direction and the radial direction of the electrodeposition drum 3, respectively. The cathode surface of the metal foil 8 obtained by this electrodeposition drum 3 reflects the drum surface of the electrodeposition drum 3, and has luster, and also has microscopic dot-shaped bumps. Hence, in an application in which linear indentations present on the surface of the metal foil cause a problem, the metal foil 8 produced by the metal foil producing method of the present embodiment is provided.

Examples of the processing method of obtaining the drum surface as shown in FIG. 2 may include a method of smoothing the surface of the electrodeposition drum 3 using a laser, for example. More specifically, for example, the drum surface 3s of the electrodeposition drum 3 is intermittently irradiated with a laser at regular intervals. As a result, portions of the metal irradiated with the laser melt or evaporate, and microscopically, a plurality of dot-shaped dents 10s, such as circles, are generated adjacent to each other; however, the surface can be processed into a mirror surface or a smooth surface close to a mirror surface.

The type of the laser used in the present embodiment is not particularly limited as long as this is a laser for metal processing; and for example, a CO₂ laser, a YAG laser, a YVO₄ laser, a fiber laser, or the like can be used alone or in combination thereof. It should be noted that a laser beam machine, which can microfabricate the entire surface of a very large drum, such as an electrodeposition drum for producing a metal foil, is not commercially available; therefore, hardware and software therefor are built by providing a new processing system in which a laser oscillator having a processing performance for a predetermined area is movably arranged and an electrodeposition drum is rotatably arranged, and in such a system, by creating a program for smoothing the drum surface by laser irradiation, for example.

The size of each dot-shaped dent 10 on the surface of the electrodeposition drum 3 is not particularly limited as long as the surface of the electrodeposition drum 3 can be processed into a flat surface; and for example, the diameter is preferably set to 100 µm or less, more preferably 50 µm or less, and further more preferably 10 µm or less. The lower limit of the diameter is not particularly limited, and is preferably set to 1 µm or more, for example. In addition, it is desirable that the upper limit of the interval between the dot-shaped dents 10 be smaller than a diameter of each dot in order to prevent influence of the unprocessed portions. For example, 50 µm or less is preferable, and 10 µm or less is more preferable. Furthermore, the lower limit of the interval is preferably set to 1 µm or more, and more preferably 2 µm or more so that the dots do not completely overlap.

The surface roughness of the drum surface 3s of the electrodeposition drum 3 is preferably set to 10 µm or less, and more preferably 5 µm or less in Rz in conformity to JIS B 0601. This surface roughness enables the drum surface 3s of the electrodeposition drum 3 to be processed into a mirror or flat surface. The lower limit of Rz is not particularly limited, and is preferably set to 0.1 µm or more, for example.

Before the laser irradiation, the surface of the electrodeposition drum 3 may be subjected to pre-processing of smoothing the drum surface to some extent. As such pre-processing, for example, other than the above-mentioned polishing with a grindstone, polishing by shot blasting, smoothing by electric discharge machining, or the like may be performed alone or in combination thereof. The surface roughness of the drum surface of the electrodeposition drum 3 before the laser irradiation is preferably set to 10 µm or less, and more preferably 5 µm or less in Rz in conformity to JIS B 0601. The lower limit of Rz before the laser irradiation is not particularly limited, but it is preferably 0.1 µm or more, for example.

Since the metal foil 8 thus obtained by the metal foil producing method of the present embodiment has the cathode surface on which the surface condition of the electrodeposition drum 3 is reflected, a plurality of dot-shaped bumps is formed as a pattern corresponding to the surface pattern of the electrodeposition drum 3. The average diameter of the dot-shaped bumps, such as circles, formed on the cathode surface of the metal foil 8 is preferably 100 µm or less, more preferably 50 µm or less, and even more preferably 10 µm, for example. The lower limit of the average diameter is not particularly limited, but is preferably 1 µm or more, for example. The average diameter is obtained by observing the surface of the metal foil 8 with a scanning electron microscope, measuring the diameters of all dot-shaped bumps in a region of 1000 µm × 1000 µm square, and calculating the average diameter thereof. When the dot-shaped bumps are not strictly circular, a virtual circle inscribing the outer shape of each dot-shaped bump is set, and the diameter of this virtual circle is measured.

The surface roughness of the cathode surface of the metal foil 8 is preferably 10 µm or less, and more preferably 5 µm or less in Rz in conformity to JIS B 0601. The lower limit of Rz of the cathode surface is not particularly limited, but is preferably set to 0.1 µm or more, for example.

Furthermore, it is preferable to set an aspect ratio of the surface texture of the cathode surface of the metal foil 8 within a range of 0.6 to 1.0 in Str in conformity to ISO 25178, and more preferably within a range of 0.7 to 0.9. This Str is an index indicating anisotropy and isotropy of the surface texture (surface roughness), and has a numerical value in a range of 0 to 1. It is indicated that the closer the Str is to 0, the stronger the anisotropy of the surface is, and the closer the Str is to 1, the stronger the isotropy of the surface is. It is indicated that at Str of 0.6 or more, the surface roughness of the cathode surface of the metal foil 8 has almost no directionality; and at Str of 0.7 or more, the surface roughness of the cathode surface of the metal foil 8 has no directionality; therefore, the surface has no linear indentations.

It is preferable to set the surface roughness Rz of the cathode surface of the metal foil 8 within a range of 1/100 to 1/10 of the average diameter of the dot-shaped bumps of the cathode surface of the metal foil 8, and more preferably within a range of 1/70 to 1/40. The relationship between the surface roughness Rz and the average diameter of the dot-shaped bumps represents an index that the surface of the cathode surface of the metal foil 8 is flat.

The degree at which the surface condition of the electrodeposition drum 3 can be reflected on the cathode surface of the metal foil 8 also depends on the electrolytic conditions. Since the electrolytic conditions also affect the physical properties of the metal foil 8 (electric conductivity, tensile strength, tension, etc.), the microscopic surface profile and the surface roughness of the cathode surface of the metal foil 8 and the physical properties of the metal foil 8 have conventionally been bound by a certain relationship. However, in the metal foil producing method of the present embodiment, the drum surface of the electrodeposition drum 3 can be formed with dot-shaped indentations, such as circles, by laser processing, while the smooth surface thereof is maintained. Accordingly, it is possible to obtain the metal foil 8 having a relationship between the microscopic surface profile as well as the surface roughness and the physical properties, which has conventionally been difficult.

The deposition surface of the metal foil 8 on the opposite side of cathode surface thereof is greatly affected by the electrolytic conditions of the electrolytic cell 1 and the thickness of the metal foil 8. Hence, in some cases, the surface condition of the electrodeposition drum 3 may be reflected on the deposition surface, and thus, a plurality of dot-shaped bumps and dents may be formed thereon; or in other cases, the bumps and the dents may become so large that these dot shapes become indistinguishable. In other words, while setting the electrolytic conditions of the electrolytic cell 1 and the thickness of the metal foil 8 to be constant, by changing the pattern of dot-shaped indentations or the like formed on the surface of the electrodeposition drum 3, it is possible to change the surface profile of the deposition surface of the metal foil 8 in accordance with the pattern. Therefore, the microscopic surface profile and the surface roughness of the deposition surface of the metal foil 8 can also be controlled by laser processing on the drum surface of the electrodeposition drum 3. The surface roughness of the deposition surface of the metal foil 8 is preferably set to 10 µm or less, and more preferably 5 µm or less in Rz in conformity to JIS B 0601. The lower limit of Rz of the deposition surface is not particularly limited, but it is preferably set to 0.1 µm or more, for example.

In the metal foil producing method of the present embodiment, for example, as the electrolytic conditions, the current density is preferably 10 to 100 A/dm², and more preferably 20 to 80 A/dm²; and the temperature of the electrolytic solution is preferably 20 to 80°C, and more preferably 30 to 60°C. The thickness of the metal foil 8 is preferably 1 to 140 µm, more preferably 3 to 105 µm, further more preferably 5 to 70 µm, and most preferably 5 to 20 µm, for example.

As described above, in the present embodiment, the case in which the plurality of dot-shaped dents 10s are formed on the surface of the electrodeposition drum 3 by laser irradiation has been described. However, the present invention is not limited to this, and the surface of the electrodeposition drum 3 may be processed by laser irradiation into a pattern having a plurality of scale-like, wavy, or chain-like curved shapes repeated respectively in the axial direction and in the radial direction of the electrodeposition drum 3, and thereby obtaining the same effect.

### EXAMPLES

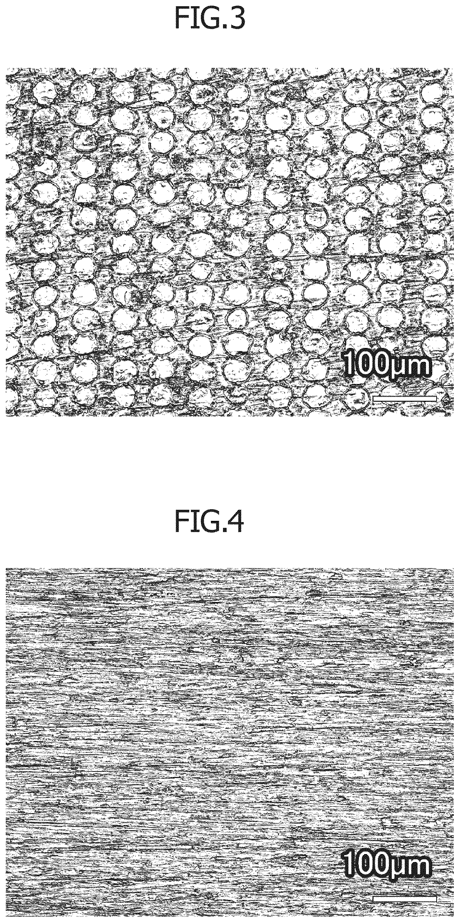

As a testing drum of an electrodeposition drum for producing an electrolytic copper foil, a cylindrical electrode made of titanium and having a diameter of 48 mm and a length of 130 mm was prepared, and the surface thereof was smoothed by laser processing. As a laser beam machine, a hybrid type of a YVO4 laser and a fiber laser (product No.: MD-X1520, manufactured by KEYENCE Corporation) were used. The laser output was set to 20 to 60% of 25 W, the pulse frequency was set to 60 to 100 kHz, the scan speed was set to 1500 to 2000 mm/s, and the drum surface was processed so that circular dot-shaped bumps and dents each having a diameter of 50 µm were formed thereon. This drum surface was observed with a shape analysis laser microscope (product No.: VK-X150/X160, manufactured by KEYENCE Corporation). FIG. 3 shows the resulting image. For comparison, FIG. 4 shows an image of a surface of a testing drum polished with a grindstone. Using the laser-processed testing drum as a cathode, a sulfuric acid-based copper electrolytic solution with a copper (II) sulfate pentahydrate concentration of 280 g/L and a sulfuric acid concentration of 90 g/L was supplied into the electrolytic cell in which said testing drum and an anode plate manufactured by DeNora Permelec Ltd. were disposed to face each other, thereby producing an electrolytic copper foil under the following conditions: current density of 45 A/dm², liquid temperature of 40 to 43°C, drum rotation speed of 300 rpm, and processing time of 60s.

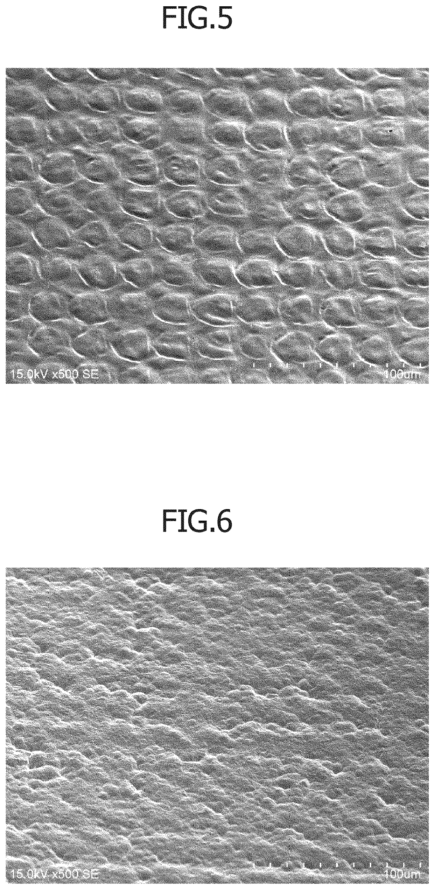

Both surfaces of the cathode surface and the deposition surface thus obtained were respectively observed with a scanning electron microscope (SEM) (product No.: SU1510, manufactured by Hitachi, Ltd.). FIG. 5 and FIG. 6 show the respective resulting SEM images. It is found that the thickness of the electrolytic copper foil is 10 µm as a result of measurement with a surface roughness measuring machine (product No.: SURFCOM 1400G, manufactured by Tokyo Seimitsu Co., Ltd.).

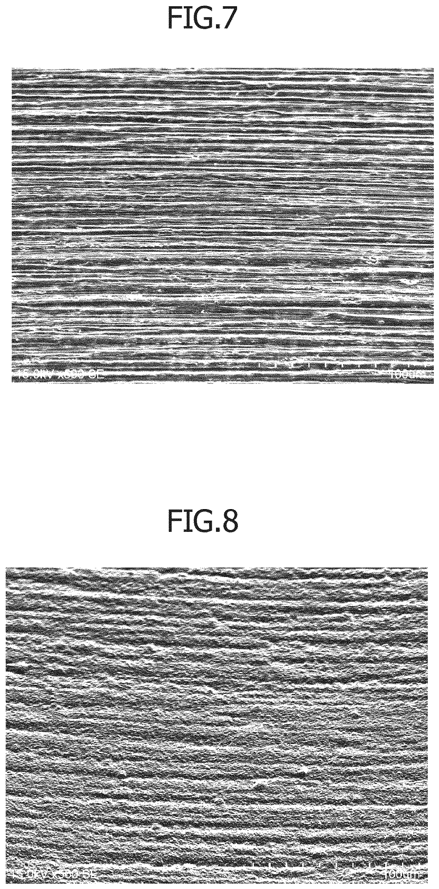

On the other hand, for comparison, an electrolytic copper foil was produced under the same conditions as those in the Embodiment Example, except that the surface of said testing drum was polished with a grindstone. FIG. 7 and FIG. 8 show respective SEM images of a cathode surface and a deposition surface of the electrolytic copper foil in this Comparative Example.

As shown in FIG. 4 and FIG. 7, it is confirmed that the cathode surface of the electrolytic copper foil of the Comparative Example, produced by using the drum having a surface polished with the conventional grindstone, reflects the surface conditions of the drum, and linear indentations are formed thereon. The deposition surface of the electrolytic copper foil of the Comparative Example is also partially formed with linear indentations, although the directionality is significantly reduced. The surface roughnesses Rz and Ra of the electrolytic copper foil of the Comparative Example were measured with a surface roughness measuring machine (product No.: SURFCOM 1400G, manufactured by Tokyo Seimitsu Co., Ltd.) in conformity to JIS B 0601; and as a result, it is found that the cathode surface has a Rz of 1.8 µm and a Ra of 0.31 µm, and the deposition surface has a Rz of 1.9 µm and a Ra of 0.37 µm, both of which are sufficiently small values as the surface roughness Rz. In addition, the aspect ratio Str was measured with the above-described shape analysis laser microscope; as a result, it was found that the aspect ratio is 0.19 in the cathode surface and 0.68 in the deposition surface, and the cathode surface has a surface profile with directionality, and this surface profile has linear indentations.

In contrast, it is confirmed that the cathode surface of the electrolytic copper foil of the Embodiment Example, produced by the drum having the surface smoothed by the laser, reflects the surface conditions of the drum, as shown in FIG. 5, and the plurality of dot-shaped bumps are formed thereon. The average diameter of the dot-shaped bumps in a 1000 µm × 1000 µm square region was 50 µm. As shown in FIG. 6, it is not obviously confirmed that the deposition surface of the electrolytic copper foil of the Embodiment Example has dot-like shapes as those in the cathode surface thereof. The surface roughness Rz of the electrolytic copper foil of the Embodiment Example was measured in the same manner as above, and as a result, it was found that the cathode surface thereof has a Rz of 1.9 µm and a Ra of 0.29 µm, and the deposition surface thereof has a Rz of 1.8 µm and a Ra of 0.36 µm; therefore, both had sufficiently small surface roughness as for the surface roughness Rz. In addition, it was found that the aspect ratio Str of the cathode surface was 0.79 and the aspect ratio Str of the deposition surface was 0.82, and both have uniform surfaces with no directionality and no linear indentations. Furthermore, it was found that the surface roughness Rz is 1/26 of the average diameter of the dot-shaped bumps, and thus both surfaces are flat.

### REFERENCE SYMBOL LIST

1: Electrolytic cell
2: Anode plate
3: Electrodeposition drum
4: Gap
5: Electrolytic solution
6: Opening
7: Wind-up drum
8: Metal foil
10: Dot-shaped dent

## Claims

1. A method for processing a surface of an electrodeposition drum for producing a metal foil, the method comprising a step of irradiating a surface of the electrodeposition drum with a laser to process the surface of the electrodeposition drum into a pattern of repeated curved shapes.

2. The processing method according to claim 1, wherein a plurality of dot-shaped dents is formed on the surface of the electrodeposition drum by the laser irradiation.

3. A method for producing a metal foil, comprising a step of providing a supply of electricity between an electrodeposition drum as a cathode and an electrode plate as an anode that are soaked in an electrolytic solution to electrodeposit metal on a surface of the electrodeposition drum with an electrolytic reaction, and thereafter peeling off the metal from the electrodeposition drum to obtain the metal foil, wherein the electrodeposition drum has a processed surface having a pattern of repeated curved shapes by laser irradiation.

4. The metal foil producing method according to claim 3, wherein the curved shapes are dot-shaped dents.

5. The metal foil producing method according to claim 3 or 4, wherein by the processed surface of the electrodeposition drum having the pattern of repeated curved shapes, a cathode surface of the metal foil, which is contact with the electrodeposition drum, is formed with a pattern corresponding to the pattern of repeated curved shapes.

6. The metal foil producing method according to any one of claims 3 to 5, wherein a surface profile formed on a deposition surface of the metal foil, which is opposite to the cathode surface, is controlled by the processed surface of the electrodeposition drum having the pattern of repeated curved shapes.

7. An electrolytic metal foil having a pattern of repeated curved shapes on a cathode surface of the electrolytic metal foil.

8. The electrolytic metal foil according to claim 7, wherein the curved shapes are dot-shaped bumps.

9. The electrolytic metal foil according to claim 8, wherein the dot-shaped bumps have an average diameter of up to 100 µm.

10. The electrolytic metal foil according to any one of claims 7 to 9, wherein a surface roughness Rz of the cathode surface of the electrolytic metal foil is up to 10 µm.

11. The electrolytic metal foil according to claim 8 or 9, wherein a surface roughness Rz of the cathode surface of the electrolytic metal foil is 1/100 to 1/10 of an average diameter of the dot-shaped bumps of the cathode surface of the electrolytic metal foil.

12. The electrolytic metal foil according to any one of claims 7 to 11, wherein an aspect ratio Str of a surface texture of the cathode surface of the electrolytic metal foil is 0.6 to 1.0.

13. A lithium-ion battery or a printed circuit board comprising the electrolytic metal foil according to any one of claims 7 to 12.
